(19) Europäisches Patentamt
European Patent Office
Office européen des brevets

(11) **EP 3 850 715 B1**

(12) **FASCICULE DE BREVET EUROPEEN**

(45) Date de publication et mention de la délivrance du brevet:
**10.08.2022 Bulletin 2022/32**

(21) Numéro de dépôt: **19829255.9**

(22) Date de dépôt: **30.10.2019**

(51) Classification Internationale des Brevets (IPC):
*H01S 3/16* (2006.01)    *H01S 3/23* (2006.01)
*C09K 11/77* (2006.01)    *C30B 11/00* (2006.01)
*C30B 29/12* (2006.01)

(52) Classification Coopérative des Brevets (CPC):
**H01S 3/1698; C09K 11/7773; C30B 11/00; C30B 29/12; H01S 3/165;** H01S 3/1611; H01S 3/1618; H01S 3/23; H01S 3/2316

(86) Numéro de dépôt international:
**PCT/FR2019/052578**

(87) Numéro de publication internationale:
**WO 2020/089563 (07.05.2020 Gazette 2020/19)**

(54) **CRISTAL LASER AVEC AU MOINS DEUX CO-DOPANTS**

LASERKRISTALL MIT MINDESTENS ZWEI CO-DOTIERSTOFFEN

LASER CRYSTAL WITH AT LEAST TWO CO-DOPANTS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **31.10.2018 FR 1860115**

(43) Date de publication de la demande:
**21.07.2021 Bulletin 2021/29**

(73) Titulaires:
• **Commissariat à l'énergie atomique et aux énergies alternatives**
**75015 Paris (FR)**
• **Université de Caen Normandie**
**14032 Caen (FR)**
• **Ensicaen**
**14050 Caen Cedex (FR)**
• **Centre National de la Recherche Scientifique**
**75794 Paris Cedex 16 (FR)**

(72) Inventeurs:
• **CAMY, Patrice**
**14050 CAEN CEDEX 04 (FR)**
• **BRAUD, Alain**
**14050 CAEN CEDEX 04 (FR)**
• **DOUALAN, Jean-Louis**
**14050 CAEN CEDEX 04 (FR)**
• **BENAYAD, Abdel**
**14050 CAEN CEDEX 04 (FR)**
• **GOOSSENS, Jean-Paul**
**33116 LE BARP CEDEX (FR)**

(74) Mandataire: **Brevalex**
**56, Boulevard de l'Embouchure**
**B.P. 27519**
**31075 Toulouse Cedex 2 (FR)**

(56) Documents cités:
**CN-A- 1 676 680    CN-A- 107 740 186**

• **VINCENT PETIT ET AL: "Spectroscopy and tunable laser operation of Yb 3+ :CaF 2 single crystals", PROCEEDINGS OF SPIE, vol. 5460, 1 septembre 2004 (2004-09-01), page 123, XP055319795, US DOI: 10.1117/12.545268 ISBN: 978-1-5106-1533-5**
• **RÉMI SOULARD ET AL: "Co-doping Nd :CaF 2 with buffer ions for inertial fusion application", ADVANCED SOLID STATE LASERS, 4 novembre 2018 (2018-11-04), XP055605690,**
• **S. NORMANI ET AL: "Site selective analysis of Nd 3+ -Lu 3+ codoped CaF 2 laser crystals", CRYSTENGCOMM, vol. 18, no. 47, 1 janvier 2016 (2016-01-01), pages 9016-9025, XP055605506, DOI: 10.1039/C6CE01966H** cité dans la demande

**Description**

**DOMAINE TECHNIQUE**

L'invention concerne le domaine des milieux amplificateurs, aptes à émettre et/ou amplifier un faisceau lumineux par effet laser.

**ÉTAT DE LA TECHNIQUE ANTÉRIEURE**

L'invention s'applique au domaine des dispositifs laser, où laser est l'acronyme de l'anglais « *light amplification by stimulated emission of radiation* » (amplification de lumière par émission stimulée de radiations, en français). Dans un dispositif laser, un milieu amplificateur, ou milieu à gain, reçoit une énergie d'excitation sous forme électrique ou optique. Cette énergie d'excitation, ou de pompage, permet d'amener certains de ses atomes à un niveau d'énergie haut (inversion de population). Les atomes situés à un niveau haut d'énergie peuvent redescendre spontanément à un niveau bas d'énergie, avec émission d'un photon. On parle alors d'émission spontanée. Le retour à un niveau bas d'énergie peut être facilité par l'arrivée d'un photon incident dont l'énergie correspond à la différence d'énergie entre le niveau haut et le niveau bas d'énergie. On parle alors d'émission stimulée. L'émission stimulée réalise une amplification de lumière, puisque le photon incident provoque l'émission d'au moins un autre photon de même énergie. On nomme « effet laser » cette amplification de lumière par émission stimulée. Le milieu amplificateur, ou milieu laser, peut amplifier un faisceau lumineux incident, par émission stimulée, au sein d'un dispositif nommé amplificateur laser. En variante, le milieu amplificateur peut émettre un faisceau lumineux à partir de photons initiaux émis par émission spontanée et initiant des émissions stimulées en cascade. Dans ce deuxième cas, le milieu amplificateur s'étend dans une cavité optiquement résonante à la longueur d'onde de l'émission stimulée, au sein d'un dispositif nommé oscillateur laser. On connaît dans l'art antérieur différents milieux amplificateurs, notamment les milieux amplificateurs solides qui regroupent les cristaux dopés et les verres dopés.

Les verres dopés ont l'avantage de présenter des spectres d'amplification avec une largeur à mi-hauteur de plusieurs nanomètres. (De même, les verres dopés présentent des spectres d'absorption avec une largeur à mi-hauteur de plusieurs nanomètres.)

On rappelle ici qu'un spectre d'amplification d'un milieu amplificateur représente la répartition spectrale du gain dudit milieu amplificateur. Il s'agit en d'autres termes de l'amplification (gain spectral) apportée par le milieu amplificateur sur un faisceau lumineux injecté en entrée de ce dernier, en fonction de la longueur d'onde dudit faisceau injecté. Un spectre de fluorescence d'un milieu amplificateur représente quant à lui la répartition spatiale de l'émission dudit milieu amplificateur, sans mécanisme d'amplification. Un spectre d'amplification (comme un spectre de fluorescence) d'un milieu amplificateur présente toujours une forme voisine d'une gaussienne sur laquelle on peut définir différents indicateurs tels que la largeur à mi-hauteur (nommée largeur du spectre) et la longueur d'onde centrale (ou longueur d'onde centrale du spectre). On nomme « bande spectrale d'amplification » la bande spectrale sur laquelle le spectre est au-dessus de la moitié de sa valeur maximale.

Les verres dopés forment en revanche de mauvais conducteurs thermiques, avec une conductivité thermique inférieure à 1 $W.m^{-1}.K^{-1}$. Cette faible conductivité thermique limite les possibilités d'évacuation de la chaleur apportée avec l'énergie d'excitation, ce qui nuit au rendement de l'amplification laser pour un fonctionnement en cadence de ce laser.

Les cristaux dopés présentent quant à eux de très bonnes conductivités thermiques, comprises généralement entre 9 et 11 $W.m^{-1}.K^{-1}$.

L'exemple le plus simple de cristal dopé est un cristal dans lequel certains des ions sont remplacés par un ion dopant dit optiquement actif, à l'origine du phénomène d'émission stimulée prépondérant dans le cristal. Un inconvénient de tels cristaux dopés est qu'ils présentent des bandes spectrales d'amplification étroites. De récentes études ont montré que ces bandes d'amplification étroites sont dues notamment à la formation, dans le cristal dopé, d'agrégats regroupant plusieurs ions optiquement actifs. Ces ions s'agrègent ensemble en réaction aux déséquilibres électriques locaux formés par les remplacements d'ions dans le cristal. Ces agrégats sont à l'origine d'un phénomène d'extinction de fluorescence (« *fluorescence quenching* », en anglais) qui limite le rendement de l'amplification laser et réduit la bande spectrale d'amplification.

Il a alors été proposé des cristaux dopés à la fois par des ions optiquement actifs, pour l'obtention de l'effet laser, et par des ions dits tampons. Les ions tampons ne participent pas directement à l'effet laser. Ils permettent simplement que les ions optiquement actifs s'agrègent avec des ions tampons plutôt qu'avec d'autres ions optiquement actifs. On limite ainsi le phénomène d'extinction de fluorescence, ce qui permet d'obtenir des bandes spectrales d'amplification plus larges. Un tel cristal est décrit dans l'article de S. Normani & al., « Site selective analysis of Nd3+-Lu3+ codoped CaF2 laser crystals », CrystEngComm 18, Janvier 2016. Dans cet article, les auteurs décrivent un cristal de $CaF_2$ dopés à la fois par des ions $Nd^{3+}$, pour obtention de l'effet laser, et par des ions $Lu^{3+}$, pour bloquer les ions $Nd^{3+}$ dans des agrégats d'un ion $Nd^{3+}$ et d'un ion $Lu^{3+}$, et éviter ainsi la formation d'agrégats de deux ions $Nd^{3+}$. On obtient ainsi un spectre d'amplification centré sur environ 1050 nm, plus large qu'en l'absence d'ions tampons dans le cristal dopé. En revanche, le spectre d'amplification s'avère très structuré, c'est-à-dire avec des rebonds à fort gradient autour du maximum.

CN 107740186 A divulgue un milieu amplificateur constitué d'un cristal de Yb, $R:CaF_2 / SrF_2$ où R est

un élément de terre rare, et est de préférence au moins un de Y, Sc, La, Gd et Lu.

Un objectif de la présente invention est de proposer un milieu amplificateur pour émettre et/ou amplifier un faisceau lumineux par effet laser, qui permette d'offrir à la fois une conductivité thermique élevée, supérieure à celle d'un verre dopé, et un spectre d'amplification large et peu structuré.

**EXPOSÉ DE L'INVENTION**

Cet objectif est atteint avec un milieu amplificateur pour émettre et/ou amplifier un faisceau lumineux par effet laser, constitué d'un cristal dopé de $X-F_2$, où X désigne un élément chimique de la famille des alcalino-terreux et F désigne le fluor, et où le cristal est dopé par des ions trivalents de terre rare, nommés ions dopants, lesdits ions dopants comprenant :

- une première catégorie d'ions dopants, nommés ions optiquement actifs, dans laquelle chaque ion dopant est un ion d'une première terre rare ; et
- une seconde catégorie d'ions dopants, nommés ions tampons, optiquement inactifs en ce qu'ils ne sont pas directement à l'origine de l'effet laser exploité dans le cristal dopé, servant uniquement à limiter la formation d'agrégats de plusieurs ions de la première catégorie d'ions dopants, dans laquelle chaque ion dopant est un ion d'une terre rare distincte de la première terre rare.

Selon l'invention, la seconde catégorie d'ions dopants comporte au moins des ions d'une deuxième terre rare et des ions d'une troisième terre rare, la deuxième terre rare et la troisième terre rare étant distinctes l'une de l'autre, où les ions de la deuxième terre rare et les ions de la troisième terre rare sont associés à des spectres de fluorescence élémentaires centrés sur des longueurs d'onde centrales respectives espacées d'au moins 3 nm, et où chaque spectre de fluorescence élémentaire désigne le spectre de fluorescence du même cristal, dopé par des mêmes ions dopants de la première catégorie d'ions dopants et co-dopé uniquement des ions de la deuxième terre rare, respectivement la troisième terre rare.

Le milieu amplificateur forme ainsi un cristal dopé, avec une conductivité thermique proche de celle d'un cristal, et bien supérieure à celle d'un verre.

Grâce aux ions tampons, on évite la formation d'agrégats de plusieurs ions optiquement actifs. On limite ainsi des phénomènes de type extinction de fluorescence, à l'origine d'une baisse du rendement énergétique, et on obtient un spectre d'amplification plus large qu'avec un cristal qui ne serait dopé que par les ions optiquement actifs.

En outre, grâce à l'utilisation de deux types d'ions tampons, correspondant à deux terres rares distinctes l'une de l'autre, on peut obtenir un spectre d'amplification plus large et moins structuré qu'avec un seul type d'ion tampon. En particulier, on peut conserver une valeur proche du maximum sur une large bande spectrale. Par exemple, on peut conserver une amplitude supérieure ou égale à 50% du maximum, sur une bande spectrale d'au moins 3 nm de large (1 nm = $10^{-9}$ m), voire au moins 5 nm de large.

Le spectre de fluorescence d'un cristal dopé correspond à un spectre d'émission de ce dernier, sans mécanisme d'amplification. Le spectre de fluorescence d'un cristal dopé est généralement bien plus large que son spectre d'amplification, mais y on retrouve les mêmes tendances, notamment en termes de largeur spectrale, structuration, et longueur d'onde centrale. L'amplification provoque un phénomène de rétrécissement spectral par le gain.

L'une des idées à la base de l'invention consiste à comparer le spectre de fluorescence d'un cristal dopé uniquement avec des ions optiquement actifs d'une première terre rare, et le spectre de fluorescence du même cristal dopé en outre avec des ions tampons d'une deuxième terre rare. On constate que l'ajout des ions tampons se traduit notamment par l'apparition d'un décalage en longueur d'onde du spectre de fluorescence. Ce décalage est fonction de la terre rare utilisée pour former lesdits ions tampons.

Les inventeurs ont pu montrer qu'en combinant plusieurs types d'ions tampons au sein d'un même cristal dopé, le spectre de fluorescence se rapproche d'une combinaison linéaire de spectres de fluorescence dits élémentaires, associés chacun à l'ajout d'un seul parmi lesdits plusieurs types d'ions tampons. En fonction des ions tampons réunis dans le cristal dopé selon l'invention, on obtient des caractéristiques données du spectre de fluorescence (largeur spectrale, longueur d'onde centrale, structuration autour du maximum avec des rebonds plus ou moins marqués, etc.). On peut ainsi choisir au moins deux types d'ions tampons, de manière à obtenir une forme souhaitée pour le spectre de fluorescence du cristal dopé, et ainsi une forme souhaitée pour son spectre d'amplification.

De préférence, le milieu amplificateur selon l'invention a sa concentration massique en ions de la deuxième terre rare qui est supérieure ou égale à 1% en masse, et sa concentration massique en ions de la troisième terre rare qui est supérieure ou égale à 1% en masse.

Sa concentration massique en ions de la deuxième terre rare est même avantageusement supérieure ou égale à 2% en masse, et sa concentration massique en ions de la troisième terre rare supérieure ou égale à 2% en masse.

Sa concentration massique en ions tampons peut être comprise entre 4% et 6%.

De préférence, lesdits ions tampons comportent des ions de lutécium, d'yttrium, de gadolinium, de lanthane, de scandium et/ou de cérium.

Lesdits ions tampons comportent avantageusement des ions d'yttrium.

Ladite seconde catégorie d'ions dopants peut être constituée desdits ions de la deuxième terre rare et desdits ions de la troisième terre rare uniquement. Avantageusement, la deuxième terre rare est l'yttrium et la troisième terre rare est le gadolinium.

En variante, ladite seconde catégorie d'ions dopants peut être constituée uniquement desdits ions de la deuxième terre rare, desdits ions de la troisième terre rare, et d'ions d'une quatrième terre rare distincte des deuxième et troisième terres rares.

L'élément chimique X désigne de préférence un élément parmi le calcium, le strontium et le baryum.

Le milieu amplificateur selon l'invention est avantageusement constitué d'un cristal dopé de fluorine, où la fluorine a pour formule $CaF_2$.

Les ions optiquement actifs peuvent être des ions de néodyme ou des ions d'ytterbium.

L'invention concerne également un dispositif laser comportant un milieu amplificateur selon l'invention, et une source lumineuse agencée pour émettre un faisceau lumineux d'excitation en direction du milieu amplificateur, le faisceau lumineux d'excitation étant apte à exciter optiquement le milieu amplificateur pour que ce dernier émette et/ou amplifie un faisceau lumineux annexe par effet laser.

Le dispositif laser selon l'invention peut comporter en outre une source lumineuse apte à émettre un faisceau lumineux à amplifier en direction du milieu amplificateur, le milieu amplificateur étant apte à amplifier par effet laser ledit faisceau lumineux à amplifier.

L'invention concerne enfin un système laser comportant une pluralité de dispositifs laser montés en cascade les uns à la suite des autres, chaque dispositif laser comprenant un milieu amplificateur et une source lumineuse agencée pour émettre un faisceau lumineux d'excitation en direction dudit milieu amplificateur, où chaque faisceau lumineux d'excitation est apte à exciter optiquement le milieu amplificateur correspondant pour que ce dernier émette et/ou amplifie un faisceau lumineux par effet laser, avec l'un au moins desdits dispositifs laser qui est un dispositif laser selon l'invention.

**BRÈVE DESCRIPTION DES DESSINS**

La présente invention sera mieux comprise à la lecture de la description d'exemples de réalisation donnés à titre purement indicatif et nullement limitatif, en faisant référence aux dessins annexés sur lesquels :

- la figure 1 illustre les spectres d'amplification respectifs de cristaux selon l'art antérieur, dopés avec des ions optiquement actifs d'une première terre rare et des ions tampons d'une seconde terre rare ;
- la figure 2 illustre de façon schématique la structure d'un cristal dopé selon l'invention ;
- la figure 3 illustre, pour une pluralité de cristaux dopés selon l'invention et selon l'art antérieur, les caractéristiques de leurs spectres d'amplification respectifs en termes de largeur spectrale et longueur d'onde centrale ;
- la figure 4 illustre des spectres de fluorescence respectifs de cristaux selon l'art antérieur et de cristaux selon un mode particulièrement avantageux de l'invention ;
- les figures 5A et 5B illustrent de façon schématique deux variantes d'un dispositif laser selon l'invention ; et
- la figure 6 illustre de façon schématique un système laser selon l'invention, avec plusieurs dispositifs laser montés en cascade.

**EXPOSÉ DÉTAILLÉ DE MODES DE RÉALISATION PARTICULIERS**

Dans tout le texte et tous les exemples, les spectres d'amplification désignent des spectres obtenus pour un gain total de $10^9$ (valeur de l'intégrale du gain spectral).

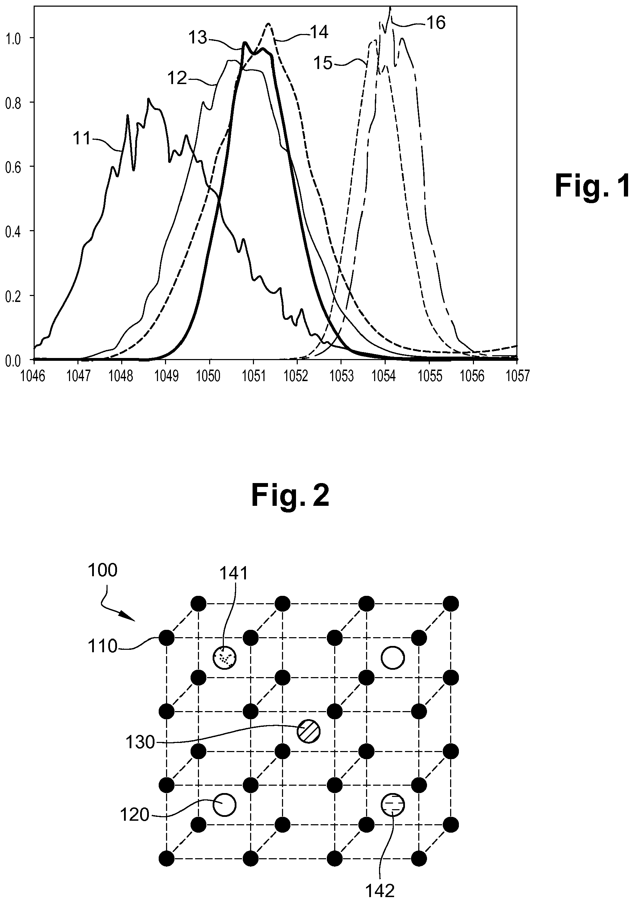

La figure 1 illustre des spectres d'amplification respectifs d'une pluralité de cristaux dopés selon l'art antérieur. L'axe des abscisses est une longueur d'onde, en nm. L'axe des ordonnées est le gain du milieu amplificateur (ou facteur d'amplification), en unité arbitraire. Le gain du milieu amplificateur est en fonction de la longueur d'onde.

Les cristaux dopés selon l'art antérieur sont des cristaux de $CaF_2$ dopés avec des ions trivalents de néodyme, $Nd^{3+}$, et des ions trivalents d'une terre rare autre que le néodyme, notés $Bu^{3+}$. Les ions de néodyme sont nommés « ions optiquement actifs », car il s'agit des ions à l'origine du phénomène d'émission stimulée exploité lorsque le cristal dopé est utilisé pour émettre et/ou amplifier un faisceau lumineux par effet laser. Les ions trivalents d'une autre terre rare sont nommés « ions tampons », car ils servent uniquement à limiter la formation d'agrégats de plusieurs ions de néodyme. Les ions tampons ne sont pas à l'origine du phénomène d'émission stimulée exploité lorsque le cristal dopé est utilisé pour émettre et/ou amplifier un faisceau lumineux par effet laser.

La concentration des ions de néodyme $Nd^{3+}$ dans le cristal dopé est de 0,5% en masse.

La concentration des ions tampons $Bu^{3+}$ dans le cristal dopé est de 5% en masse.

Le cristal est pompé optiquement par un faisceau lumineux d'excitation à 797 nm.

Les courbes 11, 12, 13, 14, 15, 16 de la figure 1 correspondent respectivement au spectre d'amplification d'un cristal dans lequel les ions tampons sont constitués d'ions de gadolinium (Gd), de cérium (Ce), de scandium (Sc), de lanthane (La), de lutécium (Lu), et d'yttrium (Y).

Chacun des spectres d'amplification présente une forme sensiblement gaussienne. Chacun des spectres d'amplification est centré sur une longueur d'onde centrale, dont la valeur est fonction de la nature des ions tampons. Ici, les valeurs de longueur d'onde centrale sont toutes proches de 1052 nm, comprises entre 1048 nm et 1055 nm.

On remarque également que les spectres d'amplification présentent de fortes structurations, c'est-à-dire de fortes variations locales autour du maximum.

L'idée à la base de l'invention consiste à réunir des ions tampons d'au moins deux types différents au sein d'un même cristal dopé de X-F$_2$, où chaque type d'ion tampon se rapporte à une terre rare distincte, où F désigne l'élément chimique Fluor, et où X désigne un élément chimique de la famille des alcalino-terreux (deuxième colonne du tableau de classification périodique des éléments, regroupant le béryllium, le magnésium, le calcium, le strontium, le baryum et le radium). X désigne plus particulièrement un élément chimique parmi le calcium (Ca), le strontium (Sr) et le baryum (Ba), et plus préférentiellement encore le calcium (Ca). Le cristal dopé de X-F$_2$ est dopé par des ions optiquement actifs d'une première terre rare, et co-dopé par des ions tampons d'au moins deux types, où chaque type se rapporte à une terre rare distincte et distincte de la première terre rare.

L'utilisation d'ions tampons d'au moins deux types permet d'obtenir un cristal dopé dont le spectre de fluorescence se rapproche d'une combinaison linéaire d'au moins deux spectres de fluorescence élémentaires, où chaque spectre de fluorescence élémentaire désigne le spectre de fluorescence du même cristal co-dopé avec un seul type d'ion tampon parmi les au moins deux types d'ions tampons. Le coefficient appliqué à chaque spectre de fluorescence élémentaire est égal à la proportion massique du type d'ion tampon correspondant, dans le cristal dopé selon l'invention, multipliée par un scalaire qui représente l'influence de ce type d'ion tampon sur la fluorescence de l'ion optiquement actif. On a ainsi :

$$f_{Tot}(\lambda) = \sum_{i=1}^{N} \alpha_i * x_i * f_i(\lambda)$$

avec $f_{Tot}(\lambda)$ une fonction qui définit le spectre de fluorescence d'un cristal dopé selon l'invention, avec au moins deux types d'ions tampons ;

$\alpha_i$ la proportion massique du $i$ ème type d'ion tampon dans le cristal dopé selon l'invention, avec un total de $N$ types d'ions tampons, où $N$ est un entier supérieur ou égal à 2 ;

$x_i$ est un scalaire qui représente l'influence du $i$ ème type d'ion tampon sur la fluorescence de l'ion optiquement actif dans le cristal dopé selon l'invention ; et

$f_i(\lambda)$ est une fonction qui définit le spectre de fluorescence du même cristal que le cristal dopé selon l'invention, excepté qu'il est co-dopé uniquement avec le $i$ ème type d'ion tampon.

On peut ainsi obtenir un cristal dopé dont le spectre de fluorescence (et par conséquent le spectre d'amplification) présente une forme souhaitée, en particulier en termes de largeur, de longueur d'onde centrale, et de structuration.

On peut obtenir en particulier un cristal dopé avec un spectre d'amplification de largeur à mi-hauteur d'au moins 3 nm (1 nm = 10$^{-9}$ m), voire au moins 5 nm. La durée d'impulsion et la largeur spectrale du spectre d'amplification étant inversement proportionnelles, un spectre d'amplification large et peu structuré est particulièrement avantageux pour produire des impulsions laser de courte durée, notamment inférieures à 1 picoseconde. Un spectre peu structuré désigne un spectre présentant un faible gradient de gain spectral autour de son maximum. De préférence, on réunit dans un cristal dopé selon l'invention des ions tampons associés à des spectres élémentaires éloignés les uns des autres. En particulier, on réunit avantageusement des ions tampons associés à des spectres élémentaires centrés sur des longueurs d'onde centrales respectives espacées d'au moins 3 nm.

On remarque que les courbes 11 à 16 de la figure 1 sont des spectres élémentaires associés à un cristal dopé de CaF$_2$, dopé avec des ions optiquement actifs de néodyme Nd$^{3+}$, et co-dopé avec au moins deux types d'ions tampons.

La courbe 11, associée à des ions tampons d'yttrium, est la plus éloignée des autres courbes associées respectivement à des ions tampons de lutécium, de lanthane, de scandium, de cérium, et de gadolinium. Il est donc avantageux de réunir, au sein d'un même cristal dopé de CaF$_2$ selon l'invention, des ions optiquement actifs Nd$^{3+}$, des ions tampons d'yttrium et des ions tampons d'au moins une autre terre rare parmi le lutécium, le lanthane, le scandium, le cérium, et le gadolinium.

Sur la figure 1, les courbes 11 et 16, associées respectivement à des ions tampons d'yttrium et de gadolinium, sont les deux courbes les plus éloignées l'une de l'autre. Ainsi, des ions tampons d'yttrium et des ions tampons de gadolinium sont avantageusement réunis au sein d'un même cristal selon l'invention, en tant qu'ions tampons de deux types distincts dans un cristal dopé de CaF$_2$ dopé avec des ions optiquement actifs de néodyme Nd$^{3+}$ et co-dopé avec au moins deux types d'ions tampons.

Le cristal dopé selon l'invention, du fait de sa structure cristalline, présente en outre une conductivité thermique du même ordre de grandeur que celle des cristaux dopés de l'art antérieur, environ dix fois supérieure à celle des verres dopés.

La figure 2 illustre de façon schématique la structure d'un cristal dopé 100 selon l'invention, constitué d'un cristal dopé de X-F$_2$.

Sur la figure 2, les ions de fluor (F$^-$) sont représentés par un disque noir 110 et les ions de l'élément chimique X (X$^{2+}$) sont représentés par un disque blanc 120. L'agencement des ions de fluor et des ions de l'élément chimique X est ici de type cubique à faces centrées, avec les ions de fluor 110 disposés sur les coins des cubes et les ions 120 de l'élément chimique X disposés sur les centres des faces des cubes. En l'absence de dopage, un cube sur deux contient un ion de l'élément chimique X.

Le cristal dopé de X-F$_2$ est dopé par des ions trivalents de terre rare nommés ions dopants. Un ion trivalent désigne un ion apte à former jusqu'à trois liaisons covalentes. Les ions dopants trivalents présentent une charge électrique positive, correspondant ici à la charge de trois protons. Une terre rare désigne un élément chimique de la famille des terres rares, la famille des terres rares regroupant le scandium (Sc), l'yttrium (Y), et les lanthanides. Les lanthanides correspondent aux éléments chimiques de numéro atomique allant de 57 à 71, et regroupant le lanthane (La), le cérium (Ce), le praséodyme (Pr), le néodyme (Nd), le prométhium (Pm), le samarium (Sm), l'europium (Eu), le gadolinium (Gd), le terbium (Tb), le dysprosium (Dy), l'holmium (Ho), l'erbium (Er), le thulium (Tm), l'ytterbium (Yb), et le lutécium (Lu).

Parmi les ions dopants, on distingue deux catégories :

- une première catégorie dans laquelle chaque ion dopant est un ion d'une première terre rare ; et
- une deuxième catégorie dans laquelle chaque ion dopant est un ion d'une deuxième terre rare distincte de ladite première terre rare.

Les ions dopants de la première catégorie sont nommés ions optiquement actifs. Il s'agit des ions à l'origine de l'effet laser exploité dans le cristal dopé 100. Les ions dopants optiquement actifs sont par exemple des ions trivalents de néodyme (Nd$^{3+}$) ou des ions trivalents d'ytterbium (Yb$^{3+}$), plus préférentiellement des ions trivalents de néodyme. Dans la suite, pour des raisons de clarté, on poursuit avec l'exemple d'ions optiquement actifs constitués d'ions trivalents de néodyme.

Les ions dopants de la deuxième catégorie sont nommés ions tampons, notés Bu$^{3+}$. Ils sont considérés comme optiquement inactifs, ou neutres, car ils ne sont pas directement à l'origine de l'effet laser exploité dans le cristal dopé 100. Ils permettent simplement de favoriser la formation d'agrégats d'au moins un ion de néodyme et au moins un ion tampon, au détriment d'agrégats regroupant seulement des ions néodyme et nuisant au rendement et à la largeur spectrale de l'amplification laser par les ions de néodyme.

Les ions tampons comportent avantageusement, des ions trivalents de lutécium (Lu$^{3+}$), des ions trivalents d'yttrium (Y$^{3+}$), des ions trivalents de gadolinium (Gd$^{3+}$), des ions trivalents de lanthane (La$^{3+}$), des ions trivalents de scandium (Sc$^{3+}$) et/ou des ions trivalents de cérium (Ce$^{3+}$). Il s'agit des ions trivalents de terre rare qui peuvent facilement entrer dans la composition du cristal de X-F$_2$ sans éteindre la luminescence de l'ion optiquement actif Nd$^{3+}$.

Les ions tampons du cristal dopé 100 sont d'au moins deux types, qui diffèrent par la nature de la terre rare correspondante. En d'autres termes, les ions tampons comportent, au moins, des ions tampons d'une deuxième terre rare (distincte de la première terre rare) et des ions tampons d'une troisième terre rare distincte de la deuxième terre rare (et de la première terre rare).

Chacun des différents ions dopants remplace un ion X$^{2+}$ dans l'agencement cubique à faces centrées du cristal. Les ions dopants aptes à remplacer un ion X$^{2+}$ dans l'agencement cubique à faces centrées sont de préférence des ions de taille comparable à celle de l'ion X$^{2+}$. Sur la figure 2, on a représenté par un disque hachuré 130 un ion optiquement actif, par un disque 141 rempli de points un ion tampon de la deuxième terre rare, et par un disque 142 rempli de dentures un ion tampon de la troisième terre rare. Les différents types d'ions dopants 130, 141, 142 sont répartis de manière homogène dans le cristal dopé 100, où chaque type d'ion dopant se rapporte à une terre rare donnée.

Le dopage nécessite en compensation de charge électrique qui se fait par des ions F$^-$ en positions interstitielles dans la maille cubique. Par souci de clarté, ces ions F$^-$ en positions interstitielles ne sont pas représentés sur la figure 2.

La figure 2 n'est pas représentative des proportions avantageuses des ions optiquement actifs 130 et des différents types d'ions tampons dans le cristal dopé 100.

La proportion massique des ions tampons de la deuxième terre rare dans le cristal dopé 100 est avantageusement supérieure ou égale à 1%, et même supérieure ou égale à 2%, et de préférence dans la limite de 5%.

De la même manière, la proportion massique des ions tampons de la troisième terre rare dans le cristal dopé 100 est avantageusement supérieure ou égale à 1%, et même supérieure ou égale à 2%, et de préférence dans la limite de 5%. Avantageusement, il en est de même pour tous les types d'ions tampons dans le cristal dopé selon l'invention, où chaque type d'ion tampon se rapporte à une terre rare donnée.

En outre, la proportion massique de l'ensemble des ions tampons dans le cristal reste avantageusement comprise entre 2% et 8% en masse, plus préférentiellement entre 3% et 7%, encore plus préférentiellement entre 4% et 6%. En-dessous d'une valeur limite basse, la proportion massique en ions tampons n'est pas toujours suffisante pour éloigner suffisamment les uns des autres les ions optiquement actifs dans le cristal dopé 100, et donc pour limiter suffisamment la formation d'agrégats de plusieurs ions optiquement actifs. Au-dessus d'une valeur limite haute, il existe un risque de déformer la maille cristalline du cristal dopé 100 et de réduire ainsi sa conductivité thermique. On peut même changer complètement la structure cristalline et obtenir un nouveau cristal qui n'a pas les propriétés physiques souhaitées.

Enfin, la proportion massique de tous les ions dopés dans le cristal dopé (ions optiquement actifs et ions tampons), est de préférence inférieure ou égale à 20%, avec au moins 0,3% en masse et même au moins 0,5% en masse d'ions dopants optiquement actifs.

De manière avantageuse, le cristal dopé 100 est constitué seulement par la matrice de X-F$_2$ dopée par les ions optiquement actifs et par les au moins deux types d'ions tampons (on néglige de préférence des éléments pouvant être présents à l'état de trace seulement, en des proportions massiques inférieures ou égales à 0,05%).

Selon un mode de réalisation avantageux, les ions tampons sont constitués de seulement deux types d'ions tampons : des ions tampons d'une deuxième terre rare (distincte de la première terre rare) et des ions tampons d'une troisième terre rare distincte de la deuxième terre rare (et de la première terre rare).

En variante, les ions tampons peuvent être constitués de trois types d'ions tampons : des ions tampons d'une deuxième terre rare (distincte de la première terre rare), des ions tampons d'une troisième terre rare distincte de la deuxième terre rare (et de la première terre rare), et des ions tampons d'une quatrième terre rare distincte des deuxième et troisième terres rares (et de la première terre rare). Des cristaux avec des ions tampons de plus de trois types ne sont pas exclus, mais on privilégie les variantes à deux ou trois types d'ions tampons qui facilitent l'obtention d'une répartition spatiale homogène des différents types d'ions dopants dans le cristal dopé 100.

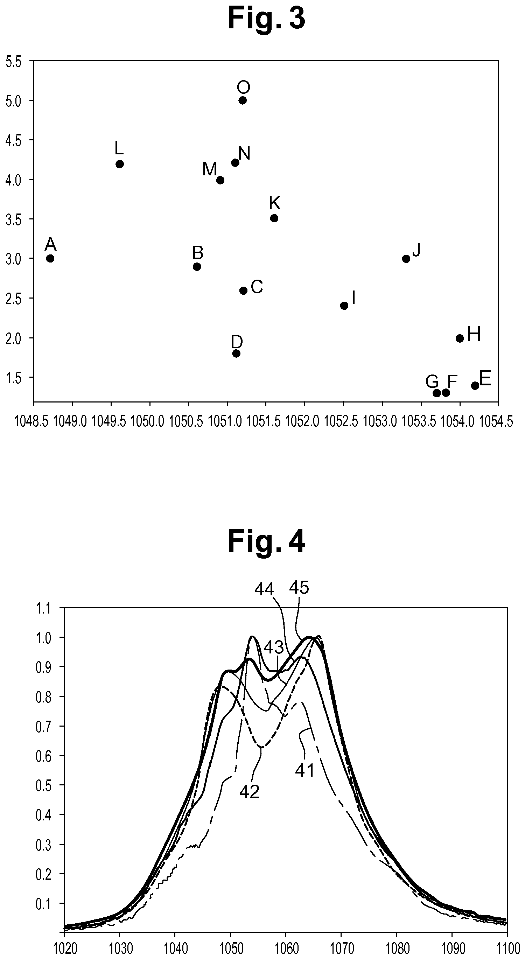

La figure 3 illustre, pour une pluralité de cristaux dopés selon l'invention et selon l'art antérieur, les caractéristiques de leurs spectres d'amplification respectifs. L'axe des abscisses est une longueur d'onde centrale du spectre d'amplification, en nm. L'axe des ordonnées est une largeur à mi-hauteur du spectre d'amplification, en nm.

Tous les cristaux sont des cristaux dopés de fluorine (CaF$_2$), dopés avec des ions optiquement actifs de néodyme (Nd$^{3+}$), et dopés en outre avec des ions tampons d'au moins un type, où chaque type d'ion tampon se rapporte à une terre rare donnée. Les spectres d'amplification sont mesurés en présence d'un pompage optique à 796 nm.

Sur la figure 3, on a identifié une série de points A à O, qui correspondent respectivement aux compositions suivantes pour les ions tampons :

A: 5% en masse de gadolinium ;
B: 5% en masse de cérium ;
C: 5% en masse de lanthane ;
D: 5% en masse de scandium ;
E: 5% en masse d'yttrium ;
F: 5% en masse de lutécium ;
G: 2,5% en masse de gadolinium et 2,5% en masse de lutécium ;
H: 1% en masse de gadolinium et 4% en masse d'yttrium ;
I: 2,5% en masse de lanthane et 2,5% en masse d'yttrium ;
J : 2,5% en masse de gadolinium et 2,5% en masse d'yttrium ;
K: 2,5% en masse de lanthane et 2,5% en masse de gadolinium ;
L: 4% en masse de gadolinium et 1% en masse d'yttrium ;
M : 1% en masse de gadolinium, 2% en masse d'yttrium, et 2% en masse de lanthane ;
N: 1% en masse de gadolinium, 2% en masse de lutécium, et 2% en masse de lanthane ;
O: 3,68% en masse de gadolinium, 0,55% en masse de lutécium, et 0,65% en masse de lanthane.

Les points A à F se rapportent à des cristaux dopés selon l'art antérieur, avec un seul type d'ion tampon. On voit sur la figure 3 qu'ils ne permettent pas d'obtenir une largeur à mi-hauteur supérieure à 3 nm. En outre, la largeur spectrale à mi-hauteur à 1053 nm est particulièrement faible, de l'ordre de 1 nm.

Les points G à O se rapportent à des cristaux dopés selon l'invention, avec deux types d'ions tampons (points G à L) ou trois types d'ions tampons (points M à O). On voit que les cristaux dopés selon l'invention permettent d'atteindre des largeurs spectrales à mi-hauteur bien supérieures à celles obtenues dans l'art antérieur, allant jusqu'à 5 nm avec trois types d'ions tampons (point O).

En outre, pour une longueur d'onde centrale donnée, par exemple 1053 nm, on peut obtenir une largeur à mi-hauteur bien supérieure à celle de l'art antérieur à cette même longueur d'onde. En particulier, des ions tampons constitués de 2,5% en masse de gadolinium et 2,5% en masse d'yttrium (point J) permettent d'obtenir une largeur à mi-hauteur de 3 nm à 1053,3 nm, contre 1nm à 1053,6 nm avec un cristal dopé de l'art antérieur (point F).

On montre ainsi qu'en choisissant astucieusement la nature et les concentrations massiques des ions tampons dans un cristal selon l'invention, on peut obtenir une bande spectrale d'amplification large et centrée sur une longueur d'onde souhaitée. Il est ainsi possible de proposer un cristal dopé apte à remplacer n'importe quel verre dopé dans un système laser complexe, en conservant la même longueur d'onde d'amplification que le verre dopé et donc sans adaptation particulière du restant dudit système laser complexe. Le remplacement d'un verre dopé par un cristal dopé selon l'invention permet d'améliorer le rendement énergétique grâce à une meilleure conductivité thermique, tout en conservant les propriétés spectrales en amplification grâce aux plusieurs types d'ions tampons judicieusement choisis.

A la figure 4, on compare des spectres de fluorescence obtenus avec des cristaux dopés selon l'art antérieur et des cristaux dopés selon l'invention, pour une même matrice de CaF$_2$ dopée par des ions optiquement actifs de néodyme et par des ions tampons d'yttrium et/ou de gadolinium. L'axe des abscisses est une longueur d'onde, en nm. L'axe des ordonnées est ici une intensité lumineuse, en unité arbitraire. Les spectres de fluorescence sont mesurés en présence d'un pompage optique à 796 nm. Chaque spectre est normalisé relativement à son maximum. Chaque spectre de fluorescence correspond à un spectre d'émission du cristal dopé, sans apport d'un faisceau lumineux à amplifier. On retrouve sur le spectre de fluorescence les mêmes tendances que sur le spectre d'amplification, notamment en termes de largeur spectrale, structuration et longueur d'onde centrale.

La courbe 41 correspond au spectre de fluorescence d'un cristal de $CaF_2$ dopé $Nd^{3+}$, et co-dopé avec des ions tampons constitués seulement d'ions d'yttrium. La courbe 41 présente ici un pic centré sur environ 1054 nm, avec un rebond moindre autour de 1063 nm.

La courbe 42 correspond au spectre de fluorescence d'un cristal de $CaF_2$ dopé $Nd^{3+}$, et co-dopé avec des ions tampons constitués seulement d'ions de gadolinium. La courbe 42 présente ici un pic centré sur environ 1066 nm, avec un rebond moindre autour de 1048 nm.

Les courbes 43, 44, 45 correspondent aux spectres de fluorescence d'un cristal de $CaF_2$ dopé $Nd^{3+}$, et co-dopé avec des ions tampons constitués d'ions de gadolinium et d'ions d'yttrium, avec 4% en masse d'ions de gadolinium et 1% en masse d'ions d'yttrium (courbe 43), respectivement 1% en masse d'ions de gadolinium et 4% en masse d'ions d'yttrium (courbe 44), et respectivement 2,5% en masse d'ions de gadolinium et 2,5% en masse d'ions d'yttrium (courbe 45).

Chacune des courbes 43 à 45 présente une large bande spectrale sur laquelle l'intensité lumineuse reste supérieure ou égale à 75% du maximum.

Chacune des courbes 43 à 45 présente une forme avec un maximum, un rebond voisin du maximum, et un creux peu marqué entre les deux. En d'autres termes, le gradient d'intensité lumineuse autour du maximum est limité, bien inférieur aux gradients d'intensité lumineuse autour du maximum sur les courbes 41 et 42. Le spectre de fluorescence est d'autant plus plat autour du maximum, que l'on se rapproche de l'égalité des pourcentages massiques d'ions d'yttrium et d'ions de gadolinium. Selon un mode de réalisation avantageux de l'invention, le cristal dopé est donc un cristal dopé de $CaF_2$ dopé $Nd^{3+}$, et co-dopé avec des ions tampons de gadolinium et d'yttrium, avec un rapport entre la plus haute valeur et la plus basse valeur parmi la concentration massique des ions d'yttrium et la concentration massique des ions de gadolinium compris entre 1 et 4, de préférence entre 1 et 2, et plus préférentiellement entre 1 et 1,5. De préférence, une concentration massique des ions de gadolinium et d'yttrium est en outre comprise entre 2% et 8%, plus préférentiellement entre 3% et 7%, encore plus préférentiellement entre 4% et 6%.

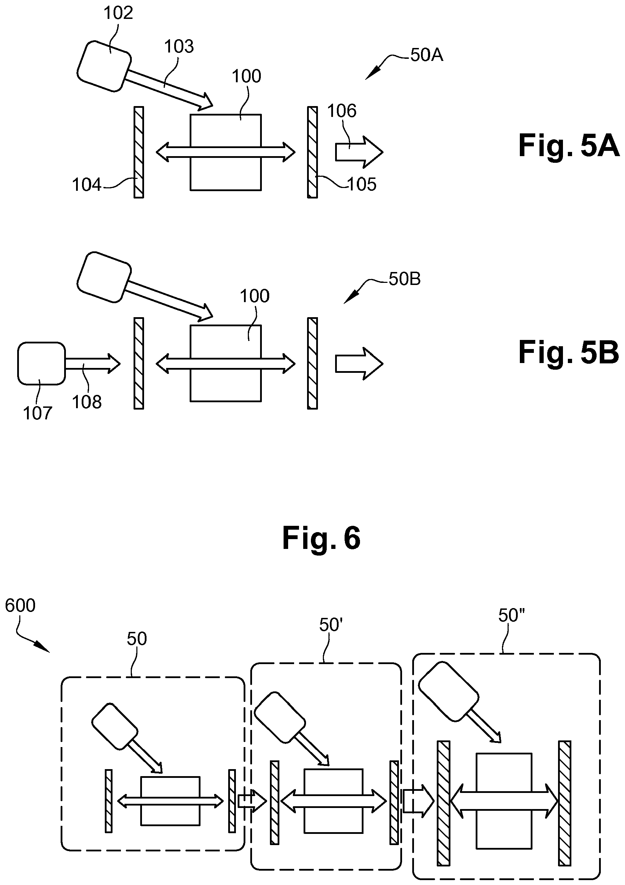

La figure 5A illustre un dispositif laser 50A selon l'invention, qui comporte un cristal dopé 100 selon l'invention, et une source lumineuse 102 configurée pour émettre un faisceau lumineux d'excitation 103 vers le cristal dopé 100. Le spectre du faisceau lumineux d'excitation 103 est centré sur une longueur d'onde apte à réaliser l'inversion de population requise pour l'obtention de l'effet laser dans le cristal dopé 100. En d'autres termes, le faisceau lumineux d'excitation 103 apporte au cristal dopé 100 l'énergie nécessaire pour amener certains de ses atomes à un niveau haut d'énergie. Le cristal dopé 100 est placé à l'intérieur d'une cavité optique résonante, formée ici par deux miroirs 104, 105 hautement réfléchissants à la longueur d'onde de l'émission stimulée dans le cristal dopé 100.

En fonctionnement, le cristal dopé 100, pompé optiquement par le faisceau lumineux d'excitation 103, émet des premiers photons par émission spontanée. Ces premiers photons provoquent l'émission de nouveaux photons par émission stimulée, lesquels circulent en boucle dans la cavité optique résonante et provoquent à leur tour l'émission de nouveaux photons par émission stimulée, jusqu'à former un faisceau lumineux 106 en sortie de la cavité optique résonante.

La figure 5B illustre une variante dans laquelle le cristal dopé 100 selon l'invention est utilisé en tant qu'amplificateur, plutôt que pour émettre un faisceau lumineux. Le dispositif laser 50B de la figure 5B n'est décrit que pour ses différences relativement au dispositif de la figure 5A. Le dispositif 50B comporte ici une source lumineuse 107, pour émettre un faisceau lumineux à amplifier 108. Le faisceau lumineux à amplifier 108 est amené jusqu'au cristal dopé 108, où il provoque l'émission stimulée et déclenche le mécanisme d'amplification. Le spectre du faisceau lumineux à amplifier 108 et le spectre d'amplification du cristal dopé 100 sont au moins partiellement superposés.

La figure 6 illustre, de façon schématique, un système 600 comportant une pluralité de dispositifs d'amplification laser 50, 50', 50" montés en cascade. Le terme « monté en cascade », signifie que les dispositifs d'amplification laser 50, 50', 50" forment un système ouvert dans lequel le faisceau lumineux émis en sortie de l'un desdits dispositifs est injecté en entrée du dispositif suivant. La sortie du dernier dispositif d'amplification laser n'est pas réinjectée en entrée d'un autre desdits dispositifs.

L'un au moins des dispositifs 50, 50', 50" est un dispositif selon l'invention, dans lequel le milieu amplificateur est un cristal dopé par des ions optiquement actifs et par des ions tampons d'au moins deux types distincts. Dans l'exemple représenté ici, mais de manière optionnelle, chaque dispositif d'amplification laser comporte une cavité optiquement résonante à la longueur d'onde de l'émission stimulée dans le milieu amplificateur.

L'un au moins des dispositifs 50, 50', 50" peut être un dispositif selon l'art antérieur, dans lequel le milieu amplificateur est un cristal dopé avec des ions optiquement actifs d'une première terre rare, et le cas échéant avec des ions tampons d'une seule et même terre rare.

Dans les exemples ci-dessus, on a illustré plus particulièrement l'exemple d'un cristal dopé de fluorine ($CaF_2$), dopé notamment avec des ions optiquement ac-

tifs de néodyme, $Nd^{3+}$. Pour autant, l'invention n'est pas limitée à cet exemple, et le principe de l'invention peut s'appliquer de la même manière à toutes sortes de cristaux dopés de type X-$F_2$, où X est un élément chimique de la famille des alcalino-terreux, dopés notamment avec des ions optiquement actifs d'une terre rare pouvant être différente du néodyme, par exemple l'ytterbium.

Le cristal dopé selon l'invention peut être synthétisé notamment par la méthode dite de Bridgman. Selon cette méthode, les matériaux à faire croître sont mis dans un creuset, puis introduits dans une enceinte sous atmosphère contrôlée et portés à une température supérieure à leur température de fusion, pour homogénéiser le mélange. L'une des extrémités du creuset est ouverte sur un cristal dit cristal-germe (« seed crystal », en anglais), et les matériaux sous forme liquide sont lentement refroidis depuis cette extrémité du creuset, avec un gradient de température pour assurer une cristallisation progressive. Il se forme alors, à partir du cristal-germe, un cristal de même orientation cristallographique que le cristal-germe et composé des matériaux présents en phase liquide dans le creuset. On utilise par exemple comme matériaux de départ du X-$F_2$ sous forme cristallisée. Les ions dopants sont obtenus à partir de poudres d'oxyde de type $Me_2O_3$, où O désigne l'oxygène et Me désigne l'élément chimique correspondant à l'ion dopant. Les poudres d'oxydes sont converties en $MeF_3$ par fluoration en bain de $NH_4HF_2$. Après pesées, les matériaux sont introduits dans le creuset. Le creuset est par exemple en graphite, de forme cylindrique, avec un canal de 2mm de diamètre dans sa partie basse pour initier la formation du cristal, du côté du cristal-germe.

L'invention offre un milieu amplificateur permettant d'obtenir une forme souhaitée du spectre d'amplification, et une forte conductivité thermique. Elle permet notamment d'obtenir un milieu amplificateur qui présente un spectre d'amplification comparable à celui d'un verre dopé tel que le phosphate, et une conductivité thermique comparable à celle d'un cristal. Elle permet notamment d'obtenir un cristal d'amplification laser, avec une large bande spectrale d'amplification et un profil contrôlé sur ladite bande. La bande spectrale d'amplification désigne de préférence une bande spectrale sur laquelle le facteur d'amplification reste supérieur ou égal à 50% du maximum.

L'invention trouve une application particulièrement avantageuse pour l'émission d'un faisceau lumineux autour de 1 $\mu$m, et plus préférentiellement entre 1040 et 1070 nm, en particulier à 1053 nm. Elle s'applique en outre à la production d'impulsions laser de forte énergie.

## Revendications

1. Milieu amplificateur (100) pour émettre et/ou amplifier un faisceau lumineux par effet laser, constitué d'un cristal dopé de X-$F_2$, où X désigne un élément chimique (120) de la famille des alcalino-terreux et F désigne le fluor (110), et où le cristal est dopé par des ions trivalents de terre rare, nommés ions dopants, lesdits ions dopants comprenant :

   - une première catégorie d'ions dopants (130), optiquement actifs, dans laquelle chaque ion dopant est un ion d'une première terre rare ;
   - une seconde catégorie d'ions dopants (141, 142), nommés ions tampons, optiquement inactifs en ce qu'ils ne sont pas directement à l'origine de l'effet laser exploité dans le cristal dopé, servant uniquement à limiter la formation d'agrégats de plusieurs ions de la première catégorie d'ions dopants (130), dans laquelle chaque ion dopant est un ion d'une terre rare distincte de la première terre rare ;

   **caractérisé en ce que** la seconde catégorie d'ions dopants comporte au moins des ions d'une deuxième terre rare (141) et des ions d'une troisième terre rare (142), la deuxième terre rare et la troisième terre rare étant distinctes l'une de l'autre ;
   et **en ce que** les ions de la deuxième terre rare (141) et les ions de la troisième terre rare (142) sont associés à des spectres de fluorescence élémentaires centrés sur des longueurs d'onde centrales respectives espacées d'au moins 3 nm, où chaque spectre de fluorescence élémentaire désigne le spectre de fluorescence du même cristal, dopé par des mêmes ions dopants de la première catégorie d'ions dopants et co-dopé uniquement des ions de la deuxième terre rare, respectivement la troisième terre rare.

2. Milieu amplificateur (100) selon la revendication 1, **caractérisé en ce que** sa concentration massique en ions de la deuxième terre rare (141) est supérieure ou égale à 1% en masse, et **en ce que** sa concentration massique en ions de la troisième terre rare (142) est supérieure ou égale à 1% en masse.

3. Milieu amplificateur (100) selon la revendication 2, **caractérisé en ce que** sa concentration massique en ions de la deuxième terre rare (141) est supérieure ou égale à 2% en masse, et **en ce que** sa concentration massique en ions de la troisième terre (142) rare est supérieure ou égale à 2% en masse.

4. Milieu amplificateur (100) selon l'une quelconque des revendications 1 à 3, **caractérisé en ce que** sa concentration massique en ions tampons (141, 142) est comprise entre 4% et 6%.

5. Milieu amplificateur (100) selon l'une quelconque des revendications 1 à 4, **caractérisé en ce que** lesdits ions tampons (141, 142) comportent des ions de lutécium, d'yttrium, de gadolinium, de lanthane, de scandium et/ou de cérium.

**6.** Milieu amplificateur (100) selon la revendication 5, **caractérisé en ce que** lesdits ions tampons (141 ; 142) comportent des ions d'yttrium.

**7.** Milieu amplificateur (100) selon l'une quelconque des revendications 1 à 6, **caractérisé en ce que** ladite seconde catégorie d'ions dopants est constituée desdits ions de la deuxième terre rare (141) et desdits ions de la troisième terre rare (142) uniquement.

**8.** Milieu amplificateur (100) selon la revendication 7, **caractérisé en ce que** la deuxième terre rare (141) est l'yttrium et la troisième terre rare (142) est le gadolinium.

**9.** Milieu amplificateur (100) selon l'une quelconque des revendications 1 à 6, **caractérisé en ce que** ladite seconde catégorie d'ions dopants est constituée uniquement desdits ions de la deuxième terre rare (141), desdits ions de la troisième terre rare (142), et d'ions d'une quatrième terre rare distincte des deuxième et troisième terres rares.

**10.** Milieu amplificateur (100) selon l'une quelconque des revendications 1 à 9, **caractérisé en ce que** l'élément chimique X (120) désigne un élément parmi le calcium, le strontium et le baryum.

**11.** Milieu amplificateur (100) selon la revendication 10, **caractérisé en ce qu'**il est constitué d'un cristal dopé de fluorine, où la fluorine a pour formule $CaF_2$.

**12.** Milieu amplificateur (100) selon l'une quelconque des revendications 1 à 11, **caractérisé en ce que** les ions optiquement actifs (130) sont des ions de néodyme ou des ions d'ytterbium.

**13.** Dispositif laser (50A; 50B) comportant un milieu amplificateur (100) selon l'une quelconque des revendications 1 à 12, et une source lumineuse (102) agencée pour émettre un faisceau lumineux d'excitation (103) en direction du milieu amplificateur, le faisceau lumineux d'excitation (103) étant apte à exciter optiquement le milieu amplificateur (100) pour que ce dernier émette et/ou amplifie un faisceau lumineux annexe (106) par effet laser.

**14.** Dispositif laser (50B) selon la revendication 13, **caractérisé en ce qu'**il comporte en outre une source lumineuse (107) apte à émettre un faisceau lumineux à amplifier (108) en direction du milieu amplificateur (100), le milieu amplificateur (100) étant apte à amplifier par effet laser ledit faisceau lumineux à amplifier (108).

**15.** Système laser (600) comportant une pluralité de dispositifs laser (50, 50', 50") montés en cascade les uns à la suite des autres, chaque dispositif laser (50; 50' ; 50") comprenant un milieu amplificateur (100) et une source lumineuse (102) agencée pour émettre un faisceau lumineux d'excitation (103) en direction dudit milieu amplificateur, où chaque faisceau lumineux d'excitation (103) est apte à exciter optiquement le milieu amplificateur correspondant pour que ce dernier émette et/ou amplifie un faisceau lumineux par effet laser, **caractérisé en ce que** l'un au moins desdits dispositifs laser (50 ; 50' ; 50") est un dispositif laser selon la revendication 13 ou 14.

**Patentansprüche**

**1.** Verstärkermedium (100) zum Ausgeben und/oder Verstärken eines Lichtstrahls durch Laserwirkung, bestehend aus einem X-$F_2$-dotierten Kristall, wobei X ein chemisches Element (120) aus der Familie der Erdalkalien und F Fluor (110) bezeichnet und wobei der Kristall mit dreiwertigen Ionen eines Seltenerdmetalls, Dotierionen genannt, dotiert ist, wobei die Dotierionen umfassen:

- eine erste Kategorie von optisch aktiven Dotierionen (130), wobei jedes Dotierion ein Ion eines ersten Seltenerdmetalls ist;
- eine zweite Kategorie von Dotierionen (141, 142), Pufferionen genannt, die insofern optisch inaktiv sind, als sie nicht direkt den im dotierten Kristall genutzten Lasereffekt bewirken, und nur dazu dienen, die Bildung von Aggregaten aus mehreren Ionen der ersten Kategorie von Dotierionen (130) zu begrenzen, wobei jedes Dotierion ein Ion eines Seltenerdmetalls ist, das sich von dem ersten Seltenerdmetall unterscheidet;

**dadurch gekennzeichnet, dass**

die zweite Kategorie von Dotierionen zumindest Ionen eines zweiten Seltenerdmetalls (141) und Ionen eines dritten Seltenerdmetalls (142) umfasst, wobei das zweite Seltenerdmetall und das dritte Seltenerdmetall voneinander verschieden sind;
und dass die Ionen des zweiten Seltenerdmetalls (141) und die Ionen des dritten Seltenerdmetalls (142) elementaren Fluoreszenzspektren zugeordnet sind, die auf jeweilige zentrale Wellenlängen zentriert sind, die zumindest 3 nm voneinander entfernt sind, wobei jedes elementare Fluoreszenzspektrum das Fluoreszenzspektrum des gleichen Kristalls bezeichnet, der mit den gleichen Dotierionen der ersten Kategorie von Dotierionen dotiert ist und nur mit Ionen des zweiten Seltenerdmetalls bzw. des dritten Seltenerdmetalls codotiert ist.

**2.** Verstärkermedium (100) nach Anspruch 1, **dadurch gekennzeichnet, dass** seine Massenkonzentration an Ionen des zweiten Seltenerdmetalls (141) größer oder gleich 1 Masse-% ist, und dass seine Massenkonzentration an Ionen des dritten Seltenerdmetalls (142) größer oder gleich 1 Masse-% ist.

**3.** Verstärkermedium (100) nach Anspruch 2, **dadurch gekennzeichnet, dass** seine Massenkonzentration an Ionen des zweiten Seltenerdmetalls (141) größer oder gleich 2 Masse-% ist, und dass seine Massenkonzentration an Ionen des dritten Seltenerdmetalls (142) größer oder gleich 2 Masse-% ist.

**4.** Verstärkermedium (100) nach einem der Ansprüche 1 bis 3, **dadurch gekennzeichnet, dass** seine Massenkonzentration an Pufferionen (141, 142) zwischen 4 % und 6 % liegt.

**5.** Verstärkermedium (100) nach einem der Ansprüche 1 bis 4, **dadurch gekennzeichnet, dass** die Pufferionen (141, 142) Lutetium-, Yttrium-, Gadolinium-, Lanthan-, Scandium- und/oder Ceriumionen umfassen.

**6.** Verstärkermedium (100) nach Anspruch 5, **dadurch gekennzeichnet, dass** die Pufferionen (141; 142) Yttriumionen umfassen.

**7.** Verstärkermedium (100) nach einem der Ansprüche 1 bis 6, **dadurch gekennzeichnet, dass** die zweite Kategorie von Dotierionen nur aus den Ionen des zweiten Seltenerdmetalls (141) und den Ionen des dritten Seltenerdmetalls (142) besteht.

**8.** Verstärkermedium (100) nach Anspruch 7, **dadurch gekennzeichnet, dass** das zweite Seltenerdmetall (141) Yttrium ist und das dritte Seltenerdmetall (142) Gadolinium ist.

**9.** Verstärkermedium (100) nach einem der Ansprüche 1 bis 6, **dadurch gekennzeichnet, dass** die zweite Kategorie von Dotierionen nur aus den Ionen des zweiten Seltenerdmetalls (141), den Ionen des dritten Seltenerdmetalls (142) und Ionen eines vierten Seltenerdmetalls, das sich von dem zweiten und dritten Seltenerdmetall unterscheidet, besteht.

**10.** Verstärkermedium (100) nach einem der Ansprüche 1 bis 9, **dadurch gekennzeichnet, dass** das chemische Element X (120) ein Element aus Calcium, Strontium und Barium bezeichnet.

**11.** Verstärkermedium (100) nach Anspruch 10, **dadurch gekennzeichnet, dass** es aus einem mit Fluorin dotierten Kristall besteht, wobei Fluorin die Formel $CaF_2$ hat.

**12.** Verstärkermedium (100) nach einem der Ansprüche 1 bis 11, **dadurch gekennzeichnet, dass** die optisch aktiven Ionen (130) Neodym-Ionen oder Ytterbium-Ionen sind.

**13.** Laservorrichtung (50A; 50B) mit einem Verstärkermedium (100) nach einem der Ansprüche 1 bis 12 und einer Lichtquelle (102), die dazu angeordnet ist, einen Anregungslichtstrahl (103) in Richtung des Verstärkermediums auszugeben, wobei der Anregungslichtstrahl (103) dazu geeignet ist, das Verstärkermedium (100) optisch anzuregen, so dass dieses einen Nebenlichtstrahl (106) ausgibt und/oder durch Laserwirkung verstärkt.

**14.** Laservorrichtung (50B) nach Anspruch 13, **dadurch gekennzeichnet, dass** sie ferner eine Lichtquelle (107) umfasst, die dazu geeignet ist, einen zu verstärkenden Lichtstrahl (108) in Richtung des Verstärkermediums (100) auszugeben, wobei das Verstärkermedium (100) dazu geeignet ist, den zu verstärkenden Lichtstrahl (108) durch Laserwirkung zu verstärken.

**15.** Lasersystem (600) mit einer Vielzahl von Laservorrichtungen (50, 50', 50"), die nacheinander in Kaskade geschaltet sind, wobei jede Laservorrichtung (50; 50'; 50") ein Verstärkermedium (100) und eine Lichtquelle (102) umfasst, die dazu angeordnet ist, einen Anregungslichtstrahl (103) in Richtung des Verstärkermediums auszugeben, wobei jeder Anregungslichtstrahl (103) dazu geeignet ist, das entsprechende Verstärkermedium optisch anzuregen, so dass dieses einen Lichtstrahl ausgibt und/oder durch Laserwirkung verstärkt, **dadurch gekennzeichnet, dass** zumindest eine der Laservorrichtungen (50; 50'; 50") eine Laservorrichtung nach Anspruch 13 oder 14 ist.

## Claims

**1.** An amplifying medium (100) for emitting and/or amplifying a light beam by laser effect, consisting of an $X-F_2$ doped crystal, where X refers to a chemical element (120) of the alkaline earth family and F refers to fluorine (110), and where the crystal is doped with trivalent ions of rare earth, called dopant ions, said dopant ions comprising:

- a first category of optically active dopant ions (130), in which each dopant ion is an ion of a first rare earth;
- a second category of dopant ions (141, 142), called buffer ions, optically inactive in that they do not directly cause the laser effect utilized in the doped crystal, being used only to limit formation of aggregates of several ions of the first category of dopant ions (130) wherein each dopant ion is an ion of a rare earth distinct from the first rare earth;

**characterized in that** the second category of dopant ions includes at least ions of a second rare earth (141) and ions of a third rare earth (142), the second rare earth and the third rare earth being distinct from each other;
and **in that** the ions of the second rare earth (141) and ions of the third rare earth (142) are associated with elemental fluorescence spectra centered on respective central wavelengths at least 3 nm apart, where each elemental fluorescence spectrum refers to the fluorescence spectrum of the same crystal, doped with the same dopant ions of the first category of dopant ions and co-doped only with ions of the second rare earth, respectively the third rare earth.

2. The amplifying medium (100) according to claim 1, **characterized in that** its mass concentration of ions of the second rare earth (141) is greater than or equal to 1% by mass, and **in that** its mass concentration of ions of the third rare earth (142) is greater than or equal to 1% by mass.

3. The amplifying medium (100) according to claim 2, **characterized in that** its mass concentration of ions of the second rare earth (141) is greater than or equal to 2% by mass, and **in that** its mass concentration of ions of the third rare earth (142) is greater than or equal to 2% by mass.

4. The amplifying medium (100) according to any of claims 1 to 3, **characterized in that** its mass concentration of buffer ions (141, 142) is between 4% and 6%.

5. The amplifying medium (100) according to any of claims 1 to 4, **characterized in that** said buffer ions (141, 142) include lutetium, yttrium, gadolinium, lanthanum, scandium and/or cerium ions.

6. The amplifying medium (100) according to claim 5, **characterized in that** said buffer ions (141; 142) include yttrium ions.

7. The amplifying medium (100) according to any of claims 1 to 6, **characterized in that** said second category of dopant ions consists of said ions of the second rare earth (141) and said ions of the third rare earth (142) only.

8. The amplifying medium (100) according to claim 7, **characterized in that** the second rare earth (141) is yttrium and the third rare earth (142) is gadolinium.

9. The amplifying medium (100) according to any of claims 1 to 6, **characterized in that** said second category of dopant ions only consists of said ions of the second rare earth (141), said ions of the third rare earth (142), and ions of a fourth rare earth distinct from the second and third rare earths.

10. The amplifying medium (100) according to any of claims 1 to 9, **characterized in that** the chemical element X (120) refers to an element from calcium, strontium and barium.

11. The amplifying medium (100) according to claim 10, **characterized in that** it consists of a fluorite-doped crystal, where the fluorite has the formula $CaF_2$.

12. The amplifying medium (100) according to any of claims 1 to 11, **characterized in that** the optically active ions (130) are neodymium ions or ytterbium ions.

13. A laser device (50A; 50B) including an amplifying medium (100) according to any of claims 1 to 12, and a light source (102) arranged to emit an excitation light beam (103) in the direction of the amplifying medium, the excitation light beam (103) being capable of optically exciting the amplifying medium (100) so that the latter emits and/or amplifies an auxiliary light beam (106) by laser effect.

14. The laser device (50B) according to claim 13, **characterized in that** it further includes a light source (107) capable of emitting a light beam to be amplified (108) in the direction of the amplifying medium (100), the amplifying medium (100) being capable of amplifying said light beam to be amplified (108) by laser effect.

15. The laser system (600) including a plurality of laser devices (50, 50', 50") cascaded one after the other, each laser device (50; 50'; 50") comprising an amplifying medium (100) and a light source (102) arranged to emit an excitation light beam (103) in the direction of said amplifying medium, wherein each excitation light beam (103) is capable of optically exciting the corresponding amplifying medium so that the latter emits and/or amplifies a light beam by laser effect, **characterized in that** at least one of said laser devices (50; 50'; 50") is a laser device according to claim 13 or 14.

Fig. 1

Fig. 2

# Fig. 3

# Fig. 4

Fig. 5A

Fig. 5B

Fig. 6

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- CN 107740186 A

**Littérature non-brevet citée dans la description**

- **S. NORMANI.** Site selective analysis of Nd3+-Lu3+ codoped CaF2 laser crystals. *CrystEngComm,* 18 Janvier 2016